# EUROPÄISCHE PATENTANMELDUNG

(11) **EP 2 003 445 A1**
(43) Veröffentlichungstag der Anmeldung: **17.12.2008**
(21) Anmeldenummer: 07110250.3
(22) Anmeldetag: 14.06.2007
(51) Int. Cl.: G01N 27/414

(54) **Ladungssensitiver Halbleitersensor**

(71) Anmelder: Mettier-Toledo AG, 8606 Greifensee (CH)
(72) Erfinder: Kittler, Gabriel, 98693, Ilmenau (DE); Ambacher, Oliver, 98693, Ilmenau (DE); Ehrismann, Philippe, 8610, Uster (CH); Bernasconi, Markus, 5012, Schönenwerd (CH); Drüe, Karl-Heinz, 98693, Oberpörlitz (DE); Hintz, Michael, 99091, Erfurt (DE); Demuth, Caspar, 8610, Uster (CH)

(57) **Zusammenfassung**

Der ladungssensitive Halbleitersensor, welcher der Bestimmung von physikalischen und/oder chemischen Eigenschaften, insbesondere der Bestimmung des pH-Werts eines Mediums, einer Flüssigkeit oder eines Gases, dient, weist eine Halbleiterstruktur (HST) auf, die wenigstens einen mit elektrischen Anschlussleitungen verbundenen Transistor (T1, T2, ...) umfasst und die, vorbehaltlich der den Steuereingang (G_{T1}, G_{T2}, ...) des Transistors (T1, T2, ...) bildenden Messschicht (MS_{T1}, MS_{T2}, ...), welcher das zu messende Medium (M) zuzuführen ist, mit einer Passivierungsschicht bedeckt ist, die aus polykristallinem anorganischem Keramikmaterial besteht.

## Beschreibung

Die vorliegende Erfindung betrifft einen ladungssensitiven; insbesondere einen ionensensitiven Sensor (ISFET) oder einen Chem-FET; mit wenigstens einem Halbleiterelement, welcher der Bestimmung von physikalischen und/oder chemischen Eigenschaften, insbesondere der Bestimmung des pH-Werts von Medien, wie Fluiden, insbesondere Flüssigkeiten oder Gasen bzw. darin enthaltenen Analyten, dient.

Die vorliegende Erfindung betrifft insbesondere einen ladungssensitiven Sensor mit einem Halbleiterelement, das nach dem Prinzip eines Feldeffekttransistors (FET) arbeitet und vorzugsweise die Struktur eines High Electron Mobility Transistors (HEMT) aufweist.

Auf der Technologie von Feldeffekttransistoren basierende ISFET-Sensoren sind beispielsweise in P. Bergveld, "Thirty years of ISFETOLOGY, What happened in the past 30 years and what may happen in the next 30 years", University of Twente, Enschede, 30 Juni 2002 oder in DE 100 62 044 A1 beschrieben.

Die in DE 100 62 044 A1 beschriebenen ISFET-Sensoren basieren auf einem speziellen Feldeffekttransistor, nämlich einem HEMT-Transistor (High Electron Mobility Transistor), der eine Heterostruktur aus Gruppe-III-Nitriden aufweist. Die oberste Schicht der Schichtfolge tritt bei der Messung in direkten Kontakt mit dem zu messenden Medium.

Gemäss DE 4308081 A1, sind in allen Anwendungsfällen eine hinreichende Langzeitstabilität, eine minimale Drift und eine einfache mechanisierbare Verkapselung der Sensorelemente eine elementare Voraussetzung für den Einsatz von ISFET's als Ionendetektoren. Die Langzeitstabilität und gleichzeitig der Drift werden wesentlich durch die eingesetzten Materialien für die ionensensitiven Schichten, die Passivierungsschichten und die Verkapselung bestimmt. Durch den Einsatz von chemisch resistenten Materialien als ionensensitive Schichten wie Al₂O₃ und Ta₂O₅ werden ISFET's realisiert, die einen Einsatz über mehrere Wochen ermöglichen. Für den Einsatz der ISFET's in wässrigen Lösungen müssen die Leiterbahnzüge, die Chipkanten und die Bonddrähte vor einem Angriff durch das Medium sicher geschützt werden.

Gemäss DE 4308081 A1 zeigen konventionelle Passivierungsschichten, wie PE-SiO₂ oder PE-Si₃N₄, auf den Leiterbahnen, die mit der Messlösung in Kontakt kommen, aufgrund ihrer relativ grossen chemischen Reaktivität eine nur geringe Stabilität und bieten somit keinen ausreichenden Schutz.

Ein guter Schutz wird gemäss DE 4308081 A1 durch eine Beschichtung des Sensors mit Polymeren (Verkapselung) erreicht, wobei Epoxidharzoder Siliconverbindungen eingesetzt werden. In der Praxis werden mittlerweile regelmässig Epoxidharze eingesetzt (siehe US 2005186697 A1). Kunstharze und spritzgiessfähige Polymere besitzen hingegen oft nicht die erforderliche Biokompatibilität, so dass deren Einsatz in den entsprechenden technologischen Gebieten unter Umständen vermieden werden muss. Ferner sind bei diesen Materialien thermische Dehnungen zu beachten, die bei hohen Temperaturänderungen kritisch sein können.

Zur Vermeidung der Probleme mit den beschriebenen Passivierungstechniken wurde in DE 4308081 A1 vorgeschlagen, die ionensensitiven Schichten und gegebenenfalls weitere Schichtfolgen rückseitig in einem abgedünnten Gebiet des Substrats anzuordenen.

In EP 0 149 330 A1 wurde hingegen vorgeschlagen, die Anschlüsse des Feldeffekttransistors zu dessen Rückseite zu führen.

Diese beiden Lösungen sind jedoch bei der Verwendung moderner Halbleiterstrukturen, insbesondere HEMT-Strukturen nur schwer realisierbar. Gegebenenfalls ist der Einsatz von Durchkontaktierungen (Via) erforderlich.

Aufgrund der beschränkten Lebensdauer von ISFET-Sensoren wurde in DE 4316003 A1 vorgeschlagen, den ISFET-Sensor mit einer Redundanz-ISFET-Einheit zu versehen, deren chemisch empfindlicher Gate-Isolator durch eine zusätzliche, gegenüber dem Messmedium resistente und den Kontakt der Membran mit dem Messmedium verhindernde Opferschicht überzogen ist, die bedarfsweise selektiv entfernbar ist. Die Verlängerung der Lebensdauer von ISFET-Sensoren bzw. mit ISFET-Sensoren versehenen Messsonden in der beschriebenen Weise ist hingegen mit relativ grossem Aufwand verbunden, da aufwendige Mittel vorgesehen werden müssen, mittels derer die beschriebene Opferschicht bedarfsweise entfernt werden kann. Zudem stellen Probleme mit bekannten Passivierungsschichten auch diese Lösung in Frage, da ein Mangel der Passivierungsschicht normalerweise zu einem Totalausfall des Sensors führt.

Der vorliegenden Erfindung liegt daher die Aufgabe zugrunde, einen nach dem Prinzip eines Feldeffekttransistors arbeitenden ladungssensitiven Sensor zu schaffen, der im Vergleich zu bekannten Sensoren eine längere Lebensdauer aufweist und mit reduziertem Aufwand herstellbar ist.

Diese Aufgabe wird mit einem ladungssensitiven Sensor gelöst, welcher die in Anspruch 1 angegebenen Merkmale aufweist. Vorteilhafte Ausgestaltungen der Erfindung sind in weiteren Ansprüchen angegeben.

Der ladungssensitive Halbleitersensor, welcher der Bestimmung von physikalischen und/oder chemischen Eigenschaften, insbesondere der Bestimmung des pH-Werts eines Mediums, einer Flüssigkeit oder eines Gases, dient, weist eine Halbleiterstruktur auf, die wenigstens einen mit elektrischen Anschlussleitungen verbundenen Transistor umfasst, und die, vorbehaltlich der den Steuereingang des Transistors bildenden Messschicht, welcher das zu messende Medium zuführbar ist, mit einer Passivierungsschicht bedeckt ist. Die Passivierungsschicht wird also so ausgebildet, dass sie die Messschicht, welche den Steuereingang des Transistors bildet, nicht bedeckt.

Erfindungsgemäss besteht die Passivierungsschicht aus polykristallinem anorganischem Keramikmaterial. Die keramische Passivierungsschicht bildet dabei ein Dielektrikum, das in Elektrolyten als Isolator wirkt und das eine hohe chemische Stabilität und eine sehr hohe CIP/SIP (Cleaning in Place / Sterilising in Place) Beständigkeit aufweist. CIP- und SIP- Prozesse und deren Auswirkungen auf die Lebensdauer einer Messsonde sind in sind in EP 1 550 861 A1 beschrieben. Mit jedem gefahrenen CIP/SIP-Zyklus verkürzt sich dabei die Lebensdauer einer Messsonde jeweils um ein bestimmtes Mass, das von der für den CIP/SIP-Zyklus vorgesehen Temperatur des Reinigungsmediums abhängig ist. Durch die erfindungsgemässe Passivierung der Halbleitersensoren reduziert sich dieses Mass bzw. erhöht sich die Lebensdauer der Halbleitersensoren signifikant.

Die Verwendung der keramischen Passivierungsschicht ist insbesondere dann besonders vorteilhaft, wenn die Halbleiterstruktur im Wesentlichen aus Gruppe III Nitriden aufgebaut ist. Die resultierenden Schichten, einschliesslich der Passivierungsschicht weisen in diesem Fall ähnliche thermische Dehnungskoeffizienten auf, so dass störende mechanische Spannungen zwischen der keramischen Passivierungsschicht und der darunter liegenden Halbleiterstruktur sogar dann entfallen, wenn CIP/SIP-Zyklen mit hohen Temperaturänderungen gefahren werden.

In einer vorzugsweisen Ausgestaltung sind auch die den Steuereingang des Transistors bildende Messschicht oder eine gegebenenfalls darüber liegende Funktionsschicht und/oder die elektrischen Anschlussleitungen ebenfalls aus polykristallinen und überwiegend oder vollständig anorganischen Stoffen gefertigt.

Die Messschicht wird vorzugsweise aus einem keramischen Material gefertigt, welches selektiv auf die zu messenden Analyten abgestimmt ist. Besonderes vorteilhaft können verschiedene selektiv ionenleitende keramische Materialien eines Halbleitersensors für die Messschichten von zwei oder mehreren Transistoren verwendet werden, die daher individuell von unterschiedlichen Anionen und/oder Kationen im Medium beeinflusst werden. Die funktionale Verwendung von Keramikmaterialien für die selektive Leitung von Ionen ist beispielsweise aus T. A. Ramanarayanan, S. C. Singhal, and E. D. Wachsman, High Temperature Ion Conducting Ceramics, The Electrochemical Society Interface, Sommer 2001, bekannt.

Aus WO 2004/034025 sind Chem-FET-Sensoren bekannt, die Funktionseinheiten aufweisen, die beim Auftreten von Analyten, insbesondere chemischen, biochemischen oder zellularen Substanzen, eine Ladungsänderung erfahren, die in einem detektierbaren Signal resultiert. Als Analyten sind u.a. Enzyme, Proteine, Nukleinsäuren, Glukose, etc. genannt.

Die in WO 2004/034025 beschriebenen Chem-FET-Sensoren weisen Nano-Drähte auf, die als Elektroden dienen, mit denen die Analyte in Wechselwirkung treten können. Sofern die Analyte einen Dipolcharakter aufweisen, erfahren die Elektroden eine Ladungsänderung, die beispielsweise von der vorliegenden oder sich ändernden Kettenbildung der Analyte bzw. der Kopplung und Ausrichtung der Dipole abhängt.

Auf die oberste Schicht einer konventionellen Halbleiterstruktur eines Sensors kann zur Messung derartiger Analyte eine Schicht aufgebracht werden, die in eine Wechselwirkung mit den Analyten tritt. Die Analyten dringen dabei in der Regel nicht in die Funktionsschicht ein, sondern wechselwirken auf molekularer Ebene mit der Funktionsschicht oder koppeln an diese an.

Alternativ sind Funktionsschichten auf die Halbleiterstruktur auftragbar, welche die Analyte selektiv passieren lassen, wodurch deren Ladungen an die tiefer liegende, ladungssensitive Schicht transferiert werden. Diese Schichtsysteme können z.B. aus so genannten Ionentauschern, wie Ceolithen, gefertigt sein, die für bestimmte Analyte selektiv durchlässig sind. In diesem Fall treten nur die durchgelassenen Analyte auf die Gate-Fläche bzw. GaN-Fläche des ISFET oder CHEMFET auf und beeinflussen dadurch den n-leitenden Kanal. Zur verbesserten Messung der Leitfähigkeit oder der pH-Werte von Flüssigkeiten kann beispielsweise eine funktionelle Schicht aus einer Keramik auf der Gate-Fläche aufgebracht sein. Eine derartige Keramik kann z.B. ein Protonenleiter sein, wie er beispielsweise unter der registrierten Bezeichnung ORMOCER bekannt ist.

Die Verwendung von Halbleitersensoren mit mehreren Transistoren mit unterschiedlich abgestimmter Gate- bzw. Messschicht erlaubt nicht nur die Messung einer einzelnen Grösse sondern die simultane Messung von mehreren Grössen des Mediums bzw. die Analyse des Ionenspektrums hinsichtlich der interessierenden Grössen. Die Anwendungen sind dabei unbeschränkt. Beispielsweise kann eine erste Grösse gemessen werden, während das Medium hinsichtlich des Auftretens einer zweiten Grösse überwacht wird, die einen gewissen Schwellwert nicht überschreiten soll.

Das für den Aufbau der Passivierungsschicht und/oder das für den Aufbau der Messschicht oder einer gegebenenfalls darüber liegenden Funktionsschicht und/oder das für den Aufbau der elektrischen Anschlussleitungen verwendete Material besteht vorzugsweise aus
a) einstoffigen Oxid-Keramiken wie Aluminiumoxid, Magnesiumoxid, Zirkoniumoxid, Titandioxid oder mehrstoffigen Oxid-Keramiken wie Aluminiumtitanat; oder aus
b) oxidfreie Keramiken; wie Carbiden, wie Siliciumcarbid, Borcarbid oder Nitriden, Siliciumnitrid, Aluminiumnitrid, Bornitrid.

Die Herstellung der keramischen Passivierungsschicht, der keramischen Mess- bzw. Funktionsschicht und/oder der elektrischen Anschlussleitungen erfolgt vorzugsweise in Siebdrucktechnik.

Die elektrischen Anschlussleitungen für die Transistoren (gegebenenfalls auch weitere elektrische Leitungen) können konventionell gefertigt werden. Besonders vorteilhaft können diese Leitungen jedoch in ursprünglich nicht-oxidiertes Keramikmaterial, wie Siliciumcarbid, Borcarbid, Siliciumnitrid, Aluminiumnitrid, Bornitrid, eingearbeitet werden, indem unter Zufuhr von Sauerstoff und gebündelter Energie, vorzugsweise mittels eines elektronisch gesteuerten Laserstrahls, die entsprechenden Anschlüsse und Bahnen oxidiert und in einen elektrisch leitenden Zustand versetzt werden. Vorzugsweise werden die elektrischen Anschlussleitungen in früheren Arbeitsschritten gefertigt und anschliessend durch die Passivierungsschicht überdeckt, die nach aussen bzw. gegen das Medium als Isolator dient.

Möglich ist ferner die Auftragung von zwei Schichten, einer äusseren isolierenden Schicht, die auch unter Einwirkung eines Laserstrahls nicht-leitend bleibt und einer darunter liegenden Schicht, die unter Wärmeeinwirkung in den leitenden Zustand versetzt wird. Durch Einwirkung der thermischen Energie kann daher die untere Schicht oxidiert werden während die obere Schicht weiterhin als Isolator erhalten bleibt.

Es wurde ferner festgestellt, dass die Ionenleitfähigkeit einer funktionalen Messschicht, die beispielsweise aus polykristallinem anorganischem Keramikmaterial, einem geringen Anteil von organischen Polymeren und/oder eingelagerten Gruppe IV-Atome, beispielsweise Siliziumatomen, besteht, unter Wärmezufuhr beispielsweise mittels eines Laserstrahls ändern. In einer vorzugsweisen Ausgestaltung werden die Messschichten, die beispielsweise aus oxidfreien Keramiken bestehen, thermisch behandelt, um die gewünschte Ionenselektivität einzustellen. Beispielsweise werden unter Wärmezufuhr organische Polymere aufgebrochen oder oxidfreie Keramiken verändert.

In vorzugsweisen Ausgestaltungen erlaubt die erfindungsgemässe Lösung daher, die gesamte Halbleiterstruktur durch keramisches Material abzudecken, wobei wenigstens zwei Zonen entstehen, die funktional unterschiedliche Eigenschaften aufweisen. Insgesamt resultiert daher ein sehr robuster Aufbau der mit Dickschichttechnologie realisiert werden kann. Grundsätzlich sind Strukturelemente, insbesondere die elektrischen Leitungen und die funktionalen Messschichten auch mit Verfahrensschritten der Dünnschichttechnologie realisierbar, die typischerweise für den Aufbau der Halbleiterstrukturen verwendet wird.

Die keramischen Materialien werden vorzugsweise im Siebdruckverfahren in Form von Pasten auf die Halbleiterstruktur aufgetragen und thermisch behandelt.

Vorzugsweise werden Niedertemperatur-Einbrand-Keramiken verwendet und nach dem entsprechenden Verfahren (LTCC) bearbeitet.

Die Halbleiterstruktur und gegebenenfalls erste keramische Schichten werden beispielsweise nach dem Verfahren der Molekularstrahlepitaxie (MBE), nach dem Verfahren der metallorganischen Gasphasenepitaxie (MOVPE/MOCVD), oder der Hydridgasphasenepitaxie (HVPE) gefertigt. Besonders vorteilhaft in Kombination mit der erfindungsgemässen Lösung sind Verfahren der Hydridgasphasenepitaxie (HVPE) anwendbar.

Nachfolgend wird die Erfindung anhand von Zeichnungen näher erläutert. Dabei zeigt:
- Fig. 1: in Schnittdarstellung einen erfindungsgemäss mit einer keramischen Passivierungsschicht P_{C} versehenen ladungssensitiven Sensor mit einer Transistorstruktur, die auf einem Substrat 1 aufgebaut ist und die im Wesentlichen aus einer auf einer Nukleationsschicht 2 gewachsenen Pufferschicht 3 und einer Barriereschicht 4 besteht, der über eine Messschicht 5 Ladungsträger aus dem Medium M zuführbar sind;
- Fig. 2: die Oberseite einer mit einer keramischen Passivierungsschicht P_{C} versehenen Halbleiterstruktur HST, in die vier Transistoren T1, ..., T4 integriert sind, deren Messschichten 5 identisch oder funktional verschieden aufgebaut sind;
- Fig. 3: die Oberseite einer mit einer keramischen Passivierungsschicht P_{C} versehenen Halbleiterstruktur HST, in die vier Transistoren T1, ..., T4 integriert sind, die mit keramischen Messschichten 105 versehen sind, die funktional identisch oder verschieden ausgestaltet sind;
- Fig. 4: die Oberseite einer mit einer keramischen Passivierungsschicht P_{C} versehenen Halbleiterstruktur HST, in die vier Transistoren T1, ..., T4 integriert sind, die mit keramischen Messschichten 205 versehen sind, die funktional verschieden ausgestaltet sind, und mit Anschlussleitungen L_{C}, die durch Energiezufuhr in eine ursprünglich nicht-leitende Keramikschicht eingearbeitet wurden;
- Fig. 5: einen Schnitt durch die Halbleiterstruktur HST von Figur 2; und
- Fig. 6: einen Schnitt durch die Halbleiterstruktur HST von Figur 4.

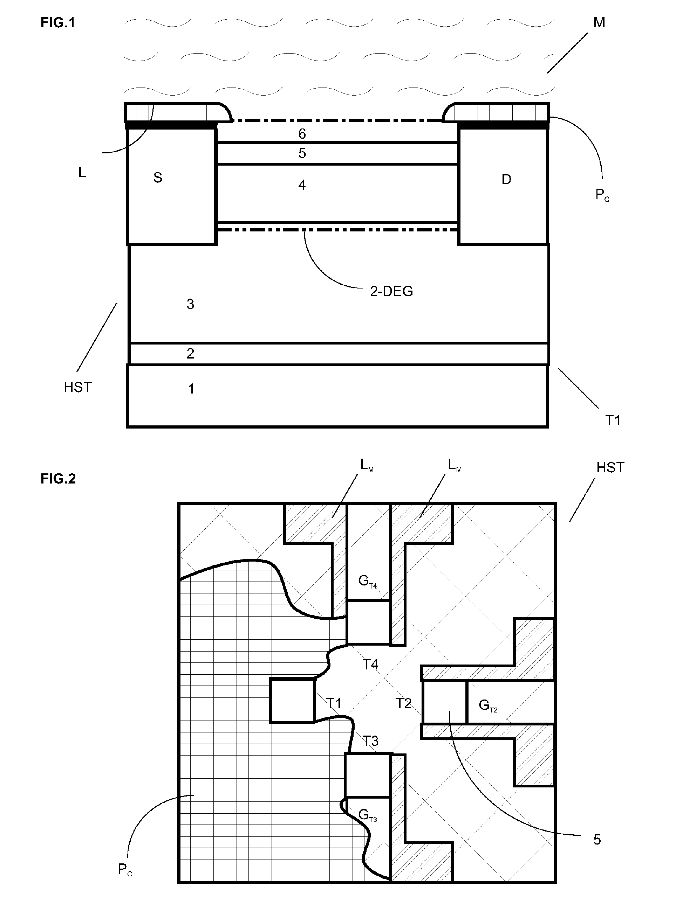

Figur 1 zeigt in Schnittdarstellung einen erfindungsgemässen ladungssensitiven Sensor mit einer Transistorstruktur, die auf einem Substrat 1 beispielsweise aus Saphir (Al₂O₃), Siliziumcarbid (SiC), Zinkoxid (ZnO), Borphosphid (BP), Galliumarsenid (GaAs), Galliumphosphid (GaP) oder Silizium (Si) aufgebaut ist. Diese Materialien werden als Ersatz für Nitrid-Volumenmaterial verwendet und sollten eine hexagonale Kristallstruktur, eine geringe Gitterfehlanpassung, einen geringen Unterschied der thermischen Ausdehnung zu GaN, und eine hohe chemische und thermische Stabilität aufweisen. Eine hohe thermische Leitfähigkeit des Substrats 1, wie sie bei der Verwendung in Leistungstransistoren erwünscht ist, ist dabei von untergeordneter Bedeutung. In der Nitridepitaxie werden zumeist Substrate 1 aus Saphir (Al₂O₃) oder Siliziumcarbid (SiC) verwendet.

Da beim Auftragen von Gallium-Verbindungen auf die genannten Substrate 1 zumeist nicht tolerierbare Gitterfehlanpassungen und zu hohe Unterschiede der thermischen Dehnungskoeffizienten resultieren, wird vorzugsweise eine an die Substratschicht anschliessende Nukleations- oder Keimschicht 2 vorzugsweise aus Aluminiumnitrid (AIN) vorgesehen, die beispielsweise eine Schichtdicke von wenigen Nanometern, zum Beispiel 5*10⁻⁹ m, bis 50*10⁻⁹ m aufweist.

Die Gitterfehlanpassungen einerseits zwischen dem Substrat 1 und der Nukleationsschicht 2 und andererseits zwischen der Nukleationsschicht 2 und der folgenden Pufferschicht 3, vorzugsweise aus GaN, werden dadurch auf ein tolerierbares Mass reduziert. Auf die Nukleationsschicht 2 kann auch eine Zwischenschicht aus AIGaN aufgetragen werden, so dass die Spannungen weiter reduziert werden.

Auf die Nukleationsschicht 2 ist eine Pufferschicht 3 aus Galliumnitrid GaN aufgetragen, an die eine Barriereschicht 4 aus Aluminium-Galliumnitrid AlGaN anschliesst.

Bei der Pufferschicht 3 und der darüberliegenden Barriereschicht 4 handelt es sich um so genannte pseudomorphe Heterostrukturen, zwischen denen eine geringe Gitterfehlanpassung erwünscht ist, die zu einer Verspannung führt. Hierdurch kommt es zur Ausbildung von piezoelektrisch induzierten, internen elektrischen Feldern am Heteroübergang und in der Folge zur Influenz des zweidimensionalen Elektronengases 2DEG, das knapp unterhalb des Heteroübergangs noch innerhalb der Pufferschicht 3 normalerweise auch dann resultiert, wenn dem Gate bzw. der Deckschicht 5 des Transistors noch keine Ladungen aus dem Medium zugeführt wurden.

Durch das Elektronengas 2DEG werden die Source-Zone S und die Drain-Zone D des Transistors elektrisch miteinander verbunden, die konventionell mit getemperten metallischen Kontakten und Leitungen L versehen sind.

Auf der Barriereschicht 4 ist eine Deckschicht 5 oder Cap Layer aus GaN aufgetragen, die nachfolgend als Messschicht bezeichnet wird, da sie während der Verwendung des Halbleitersensors mit dem Medium M in Verbindung steht und Analyte gegebenenfalls selektiv aufnimmt oder mit diesen in eine Wechselwirkung tritt. An der Oberfläche bildet sich beispielsweise GaₓO_{y} und in wässrigen Lösungen bilden sich dann an den Oberflächen amphotere Hydroxylgruppen, die protoniert und deprotoniert werden können. Die somit als Steuereingang des Transistors T1 dienende Messschicht 5 kann zusätzlich mit einer besonderen Funktionsschicht abgedeckt oder selbst als Funktionsschicht ausgestaltet sein, die nur bestimmte Analyte passieren lässt.

Die Oberseite der Halbleiterstruktur HST einschliesslich der metallischen Kontakte und Anschlussleitungen L des Transistors T1, jedoch ohne die Messschichten 5 bzw. die Deckschichten der Transistoren T1, ..., T4, ist erfindungsgemäss mit einer keramischen Passivierungsschicht P_{C} abgedeckt.

Die Passivierungsschicht P_{C} kann in bekannter Weise in Dickschichttechnologie gefertigt werden. Dazu wird eine Keramikpaste (beispielsweise QM42 von der Fa. DuPont) mit einem Siebdruckverfahren aufgetragen und anschliessend gebrannt. Mittels der Pasten LF500 (Fa. DuPont) und IP9036A (Fa. Heraeus) können ferner Glasuren gebildet werden.

Besonders vorteilhaft ist auch die Technologie der Low Temperature Cofired Ceramics (LTCC) (Niedertemperatur-Einbrand-Keramiken) verwendbar, die üblicherweise in der Leiterplattenfertigung verwendet wird. Das Material der Passivierungsschicht P_{C} wird durch Siebdruck oder photochemische Prozesse, gegebenenfalls in mehreren funktional verschiedenen Lagen aufgebracht und mit einem definierten Sinterprofil mit einer Spitzentemperatur von etwa 850 - 900 °C (bei Glasuren etwa 600°C) gebrannt.

Die LTCC-Technologie, vereinigt die Vorteile der HTCC (High Temperature Cofired Ceramics) und der Dickschichttechnologie und kann mit Dickschichteinrichtungen angewendet werden. Die Keramikmasse ist mit Plastifikatoren und Lösungsmitteln versehen, um das Laminieren unter Temperatur und Druck zu ermöglichen.

In Figur 1 ist ferner das Medium M mit darin vorhandenen ionischen Analyten schematisch gezeigt, welches über die Deckschicht auf den Transistor einwirkt. Als Analyt kann das Medium beispielsweise H₃O⁺ oder andere Anionen oder Kationen aufweisen.

Figur 2 zeigt die Oberseite einer mit einer keramischen Passivierungsschicht Pc versehenen Halbleiterstruktur HST, in die vier Transistoren T1, ..., T4 beispielsweise mit der in Figur 1 gezeigten Architektur integriert sind. Die Anschlüsse L_{M} der Transistoren T1, ..., T4, die aus getemperten Metallen, beispielsweise 20 nm Ti, 100 nm Al, 45 nm Ni und 55 nm Au, bestehen, sind durch die Passivierungsschicht P_{C} abgedeckt. Der Aufbau dieser Kontaktierungen kann durch den Anwender entsprechend seinen Anforderungen jedoch passend gewählt werden.

Die als Steuerelektroden G_{T1}, G_{T2}, ... dienenden Messschichten 5 der Transistoren T1, T2, die identisch oder funktional verschieden aufgebaut sind, liegen hingegen frei. Alternativ könnte die Messschicht 5 wenigstens eines Transistors T ebenfalls mittels einer Keramikschicht abgedeckt sein, die aufgebrochen wird, wenn ein Ersatz für einen anderen Transistor benötigt wird. Die als Opferschicht dienende Keramikschicht kann, im Vergleich zu den in DE 4 316 003 A1 beschriebenen Opferschichten durch eine mechanische Einwirkung, beispielsweise mittels eines Stempels, mit geringem Aufwand aufgebrochen werden. Sofern die Messschichten 5 des Halbleitersensors unterschiedlich ausgestaltet sind, kann auch wenigstens eine passende Messschicht 5 freigelegt werden (beispielsweise sind ursprünglich alle Messschichten 5 abgedeckt).

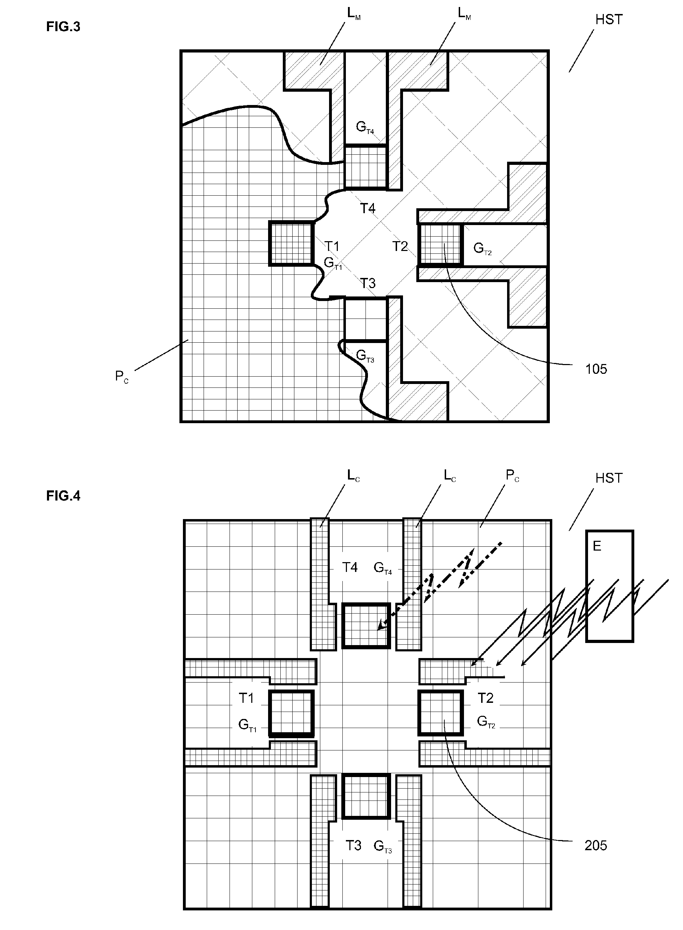

Figur 3 zeigt die Oberseite einer mit einer keramischen Passivierungsschicht P_{C} versehenen Halbleiterstruktur HST, in die vier Transistoren T1, ..., T4 integriert sind, die mit keramischen Messschichten 105 versehen sind. Die keramischen Messschichten 105 sind funktional unterschiedlich ausgestaltet. Die Messschichten 105 bestehen vorzugsweise aus polykristallinem anorganischem Keramikmaterial, einem geringen Anteil organischer Polymeren und/oder eingelagerten Gruppe IV-Atomen, beispielsweise Siliziumatomen. Durch die Wahl der Materialien und der Anteile von organischen Polymeren und/oder eingelagerten Gruppe IV-Atomen können die Eigenschaften bedarfsweise eingestellt werden. Eine derartige leitende Keramik kann z.B. ein Protonenleiter sein, wie er beispielsweise unter der registrierten Bezeichnung ORMOCER bekannt ist. Funktionalen Keramikmaterialien sind ferner in T. A. Ramanarayanan, S. C. Singhal, and E. D. Wachsman, High Temperature Ion Conducting Ceramics, The Electrochemical Society Interface, Sommer 2001 beschrieben. Wie oben erwähnt, können die Eigenschaften vorteilhaft durch Zufuhr von Energie beispielsweise mittels eines Laserstrahls eingestellt werden, wie das in Figur 4 gezeigt ist.

Figur 4 zeigt die Oberseite einer mit einer keramischen Passivierungsschicht P_{C} versehenen Halbleiterstruktur HST, in die vier Transistoren T1, ..., T4 integriert sind, die mit funktional verschiedenen keramischen Messschichten 205 versehen sind. Wie in Figur 4 weiter gezeigt ist, werden die Anschlussleitungen L_{C} der Transistoren durch Energiezufuhr in eine ursprünglich nicht-leitende Keramikschicht beispielsweise in die Passivierungsschicht, oder eine Schicht davon, eingearbeitet. Dazu werden die Zonen der nicht-leitenden Keramikschicht, die für die Leiterbahnen vorgesehen sind mittels des Laserstrahls einer Lasereinheit E fortlaufend verändert. Die Veränderung von nicht-leitendem in leitendes Keramikmaterial ist in US 5'145'741 beschrieben. In Figur 4 ist der Moment gezeigt, in dem mittels der Lasereinheit, welche den Laserstrahl beispielsweise über einen gesteuerten Spiegel auf die Keramikfläche gelenkt, die Anschlussleitungen L_{C}, vorzugsweise auch die Kontaktierungen des Transistors T2 gefertigt werden. Aufgrund der Integration der Anschlussleitungen in das Keramikmaterial entfallen Unterschiede der Dehnungskoeffizienten vollständig. CIP/SIP-Prozesse können daher in beliebiger Anzahl gefahren werden, ohne dass Mängel bei den elektrischen Zuleitungen auftreten.

Das für den Aufbau der Passivierungsschicht und/oder das für den Aufbau der Messschicht oder einer gegebenenfalls darüber liegenden Funktionsschicht und/oder das für den Aufbau der elektrischen Anschlussleitungen verwendete Material besteht vorzugsweise aus
a) einstoffigen Oxid-Keramiken wie Aluminiumoxid, Magnesiumoxid, Zirkoniumoxid, Titandioxid oder mehrstoffigen Oxid-Keramiken wie Aluminiumtitanat; oder aus
b) oxidfreien-Keramiken; wie Carbiden, wie Siliciumcarbid, Borcarbid oder Nitriden, Siliciumnitrid, Aluminiumnitrid, Bornitrid.

Für Keramikschichten, die partiell in leitende Zonen gewandelt werden sollen, werden vorzugsweise oxidfreien -Keramiken verwendet. Durch die Einarbeitung der Anschlussleitungen in die Keramikschichten gelingt es, Mängel der elektrischen Kontaktierung praktisch vollständig zu vermeiden. Ferner lassen sich höhere Packungsdichten realisieren. Gegebenenfalls sind die betreffenden Keramikmaterialien in mehreren Schichten aufzutragen, was mittels der LTCC-Technologie gut beherrschbar ist.

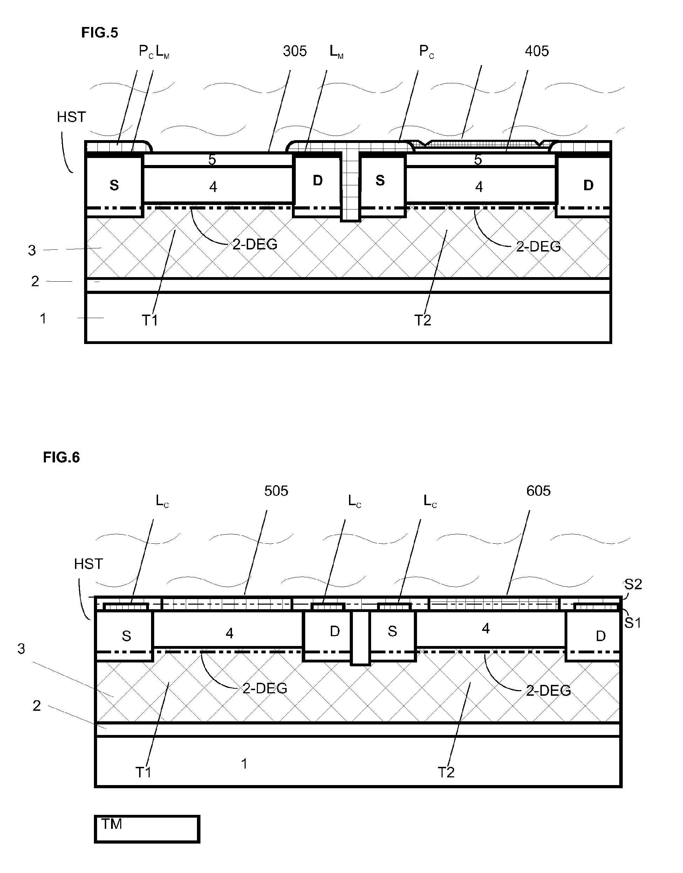

Figur 5 zeigt einen Schnitt durch die Halbleiterstruktur HST von Figur 2. Die Halbleiterstruktur HST mit den darauf vorgesehenen metallischen Kontaktierungen und Leitungen LM ist mit der keramischen Passivierungsschicht P_{C} überdeckt. Freigehalten sind nur die Messschichten 305, 405 der gezeigten Transistoren T1, T2. Diese Messschichten 305, 405, welche die Cap Layers bzw. Deckschichten oder Kappen der Transistoren T1, T2 bilden, weisen eine unterschiedliche Selektivität, Leitfähigkeit oder Wechselwirkung mit Analyten auf, so dass anhand des Halbleitersensors Informationen über mehrere Eigenschaften der Analyte und des Mediums gewonnen werden können. Sofern eine genügend hohe Anzahl von Transistoren T1, T2, ... mit entsprechend ausgestalteten Messschichten 305, 405, ...... vorgesehen ist, kann das Spektrum der Analyten, gegebenenfalls das Ionenspektrum des Messmediums M analysiert werden. Aufgrund der hohen Packungsdichte der Halbleiterstrukturen HST, kann ein multifunktionaler Halbleitersensor mit denselben oder nur unwesentlich grösseren Abmessungen und nur mit geringem zusätzlichem Aufwand gefertigt werden.

In Figur 5 ist ferner gezeigt, dass über der Messschicht 305 des Transistors T2 optional eine keramische Opferschicht O_{C}, beispielsweise ein dünnes Keramikplättchen vorgesehen ist, weiches leicht aufgebrochen werden kann, um den Transistor T2 zu aktivieren.

Figur 6 zeigt einen Schnitt durch die Halbleiterstruktur HST von Figur 4. Es ist gezeigt, dass die Halbleiterstruktur HST durch eine Keramikstruktur abgedeckt ist, die verschiedene Zonen aufweist und teilweise Strukturelemente konventioneller ISFET-Strukturen ersetzt. Die Deckschichten der Transistoren T1, T2 werden durch keramische, vorzugsweise funktional verschiedene Keramikschichten 505, 605, gebildet. Die Kontakte und Anschlussleitungen L_{C} wurden in die Keramikschichten eingearbeitet. Sofern für die oberste Schicht des Transistors bereits eine Keramikschicht vorgesehen ist, wird diese vorzugsweise aus konvertierbarem Keramikmaterial gefertigt, so dass dieses bedarfsweise strukturiert bzw. mit elektrisch leitenden Bahnen und Anschlüssen versehen werden kann.

In vorzugsweisen Ausgestaltungen werden daher Verfahren der Dünnschichttechnologie, beispielsweise Verfahren der Gasphasenabscheidung, und der Dickschichttechnologie und/oder der LTCC-Technologie miteinander kombiniert. Mittels Gasphasenabscheidung können beispielsweise Siliziumcarbid oder Aluminiumnitrid auf die Halbleiterstruktur HST aufgetragen werden. In die aufgetragene keramische Siliziumcarbidschicht oder in die Aluminiumnitridschicht werden dann mittels eines Laserstrahls die Kontakte und Leiterbahnen eingearbeitet. Anschliessend können die Messschichten und die Passivierungsschicht aufgetragen werden. Wesentlich dabei ist, dass die Keramikschichten in genügender Dicke aufgetragen werden oder die Intensität des Lasers entsprechend eingestellt wird, so dass eine Konversion und nicht eine Zerstörung der betreffenden Keramikzonen resultiert.

Bei der Verwendung der LTCC-Technologie können mehrere Keramikschichten, beispielsweise eine Keramikschicht mit elektrischen Leitungen, eine Keramikschicht mit selektiven Messschichten und eine Passivierungsschicht laminiert werden. In Figur 6 sind symbolisch zwei Schichten S1, S2 gezeigt.

In Figur 6 ist ferner eine Auswerteeinheit TM gezeigt, beispielsweise ein in der EP 1 550 861 A1 beschriebener Transmitter, mittels dessen die vom gegebenenfalls multifunktionalen Halbleitersensor gelieferten Signale verarbeitet werden. Verstärkereinheiten, beispielsweise Impedanzwandler, A/D-Wandler und Datenverarbeitungselemente können auch in den erfindungsgemässen Halbleitersensor integriert werden.

## Patentansprüche

1. Ladungssensitiver Halbleitersensor zur Bestimmung von physikalischen und/oder chemischen Eigenschaften, insbesondere zur Bestimmung des pH-Werts eines Mediums, einer Flüssigkeit oder eines Gases, mit einer Halbleiterstruktur (HST), die wenigstens einen mit elektrischen Anschlussleitungen verbundenen Transistor (T1, T2, ...) aufweist und die, vorbehaltlich der den Steuereingang (G_{T1}, G_{T2}, ...) des Transistors (T1, T2, ...) bildenden Messschicht (5, 105, 205, ...), welcher das zu messende Medium (M) zuzuführen ist, mit einer Passivierungsschicht bedeckt ist, **dadurch gekennzeichnet, dass** die Passivierungsschicht (P_{C}) aus polykristallinem anorganischem Keramikmaterial besteht.

2. Ladungssensitiver Halbleitersensor nach Anspruch 1, **dadurch gekennzeichnet, dass** die Passivierungsschicht (P_{C}) ein Dielektrikum bildet.

3. Ladungssensitiver Halbleitersensor nach Anspruch 1 oder 2, **dadurch gekennzeichnet, dass** die Messschicht (5, 105, 205, ...) oder eine gegebenenfalls darüber liegende Funktionsschicht und/oder die elektrischen Anschlussleitungen (L_{C}) ebenfalls aus polykristallinen und überwiegend oder vollständig anorganischen Stoffen gefertigt sind.

4. Ladungssensitiver Halbleitersensor nach einem der Ansprüche 1 bis 3, **dadurch gekennzeichnet, dass** die Messschicht (5, 105, 205, ...) aus einem selektiv ionenleitenden keramischen Material gefertigt ist, welches auf die zu messenden Medien (M) abgestimmt ist oder dass mehrere Transistoren (T1, T2, ...) mit Messschichten (5, 105, 205, ...) vorgesehen sind, von denen zumindest zwei Messschichten (5, 105, 205, ...) der selektiven Leitung von unterschiedlichen Anionen und/oder Kationen dienen.

5. Ladungssensitiver Halbleitersensor nach einem der Ansprüche 1 bis 4, **dadurch gekennzeichnet, dass** das für den Aufbau der Passivierungsschicht (P_{C}) und/oder das für den Aufbau der Messschicht (5, 105, 205, ...) oder einer gegebenenfalls darüber liegenden Funktionsschicht und/oder das für den Aufbau der elektrischen Anschlussleitungen (L_{C}) verwendete Material aus
a. einstoffigen Oxid-Keramiken wie Aluminiumoxid, Magnesiumoxid, Zirkoniumoxid, Titandioxid oder mehrstoffigen Oxid-Keramiken wie Aluminiumtitanat; oder aus
b. Oxidfreien-Keramiken; wie Carbide, wie Siliciumcarbid, Borcarbid oder Nitriden, Siliciumnitrid, Aluminiumnitrid, Bornitrid,
besteht.

6. Ladungssensitiver Halbleitersensor nach einem der Ansprüche 1 bis 5, **dadurch gekennzeichnet, dass** die Passivierungsschicht (P_{C}), gegebenenfalls die Mess- bzw. Funktionsschicht (5, 105, 205, ...) und/oder die elektrischen Anschlussleitungen (L_{C}) in Siebdrucktechnik gefertigt sind.

7. Ladungssensitiver Halbleitersensor nach einem der Ansprüche 1 bis 5, **dadurch gekennzeichnet, dass** die elektrischen Anschlussleitungen (L_{C}) in ursprünglich nicht-oxidiertes Keramikmaterial, wie Siliciumcarbid, Borcarbid, Siliciumnitrid, Aluminiumnitrid, Bornitrid, eingearbeitet sind, indem unter Zufuhr von Sauerstoff und gebündelter Energie, vorzugsweise mittels eines elektronisch gesteuerten Laserstrahls, die entsprechenden Anschlüsse und Bahnen oxidiert und in einen elektrisch leitenden Zustand versetzt wurden und/oder dass die funktionalen Eigenschaften der keramischen Messschicht (5, 105, 205, ...) unter Zufuhr von Sauerstoff und gebündelter Energie, vorzugsweise mittels eines elektronisch gesteuerten Laserstrahls, in die wenigstens eine keramische Messschicht (5, 105, 205, ...) eingeprägt sind.

8. Ladungssensitiver Halbleitersensor nach einem der Ansprüche 1 bis 7, **dadurch gekennzeichnet, dass** die Signale der mit funktional unterschiedlichen Messschichten (5, 105, 205, ...) versehenen Transistoren (T1, T2, ...) getrennt zu einer Auswerteeinheit (TM) führbar sind.

9. Ladungssensitiver Halbleitersensor nach einem der Ansprüche 1 bis 8, **dadurch gekennzeichnet, dass** die gesamte Halbleiterstruktur (HST) durch keramisches Material mit wenigstens zwei Zonen abgedeckt ist, die unterschiedliche Eigenschaften aufweisen.

10. Ladungssensitiver Halbleitersensor nach einem der Ansprüche 1 bis 9, **dadurch gekennzeichnet, dass** die wenigstens eine funktionale Messschicht und/oder die für die Einarbeitung elektrischer Bahnen vorgesehene Keramikschicht, die gegebenenfalls Teil der Passivierungsschicht ist, in Dünnschichttechnik oder in Dickschichttechnik gefertigt sind.

11. Ladungssensitiver Halbleitersensor nach einem der Ansprüche 1 bis 10, **dadurch gekennzeichnet, dass** die wenigstens eine funktionale Messschicht (5, 105, 205, ...) und/oder die für die Einarbeitung der elektrischen Anschlussleitungen (L_{C}) vorgesehene Keramikschicht in einem ersten Arbeitsschritt und die Passivierungsschicht (P_{C}) in einem folgenden zweiten Arbeitsschritt gefertigt ist.

12. Ladungssensitiver Halbleitersensor nach einem der Ansprüche 1 bis 11, **dadurch gekennzeichnet, dass** die keramischen Materialien im Siebdruckverfahren in Form von Pasten auf die Halbleiterstruktur (HST) aufgetragen und thermisch behandelt sind und/oder dass die keramischen Materialien nach der LTCC-Technolgie gefertigt sind.

13. Ladungssensitiver Halbleitersensor nach einem der Ansprüche 1 bis 12, **dadurch gekennzeichnet, dass** die Halbleiterstruktur (HST) nach dem Verfahren der Molekularstrahlepitaxie (MBE), nach dem Verfahren der metallorganischen Gasphasenepitaxie (MOVPE/MOCVD), oder der Hydridgasphasenepitaxie (HVPE) gefertigt ist.

14. Ladungssensitiver Halbleitersensor nach einem der Ansprüche 1 bis 13, **dadurch gekennzeichnet, dass** der wenigstens eine Transistor (T1, T2, ...) der Halbleiterstruktur (HST) eine HEMT-Struktur aufweist und/oder dass der wenigstens eine Transistor (T1, T2, ...) der Halbleiterstruktur (HST) aus Material von Gruppe-III-Nitriden besteht.

15. Ladungssensitiver Halbleitersensor nach einem der Ansprüche 1 bis 14, **dadurch gekennzeichnet, dass** eine Messschicht (5) mit einer keramischen Opferschicht (O_{C}) bedeckt ist.
